**Europäisches Patentamt**

**European Patent Office**

**Office européen des brevets**

(19)

(11) Veröffentlichungsnummer: **0 193 049 B1**

(12) **EUROPÄISCHE PATENTSCHRIFT**

(45) Veröffentlichungstag der Patentschrift: **21.11.91**

(51) Int. Cl.5: **H03G 3/20**, H04M 3/50

(21) Anmeldenummer: **86101899.2**

(22) Anmeldetag: **14.02.86**

(54) **Verfahren zur Pegelregulierung von Nachrichteninformationen.**

(30) Priorität: **01.03.85 DE 3507343**

(43) Veröffentlichungstag der Anmeldung:
**03.09.86 Patentblatt 86/36**

(45) Bekanntmachung des Hinweises auf die
Patenterteilung:
**21.11.91 Patentblatt 91/47**

(84) Benannte Vertragsstaaten:
**AT BE CH FR GB LI NL SE**

(56) Entgegenhaltungen:
**US-A- 4 351 983**

**IBM TECHNICAL DISCLOSURE BULLETIN,
Band 18, Nr 2, Juli 1975, Seiten 438-439, New
York, US; J. BESSEYRE: "Digital automatic
gain control circuit"**

**ELECTRONICS LETTERS, Band 16, Nr. 3, 31.
Januar 1980, Seiten 96,97, London, GB; J.
FLOOD: "New digital automatic gain control
for P.C.M. signals"**

**Limann et al: "Funktechnik ohne Ballast",1984,Franzis, München, Seiten 228-239**

(73) Patentinhaber: **SIEMENS AKTIENGESELL-
SCHAFT
Wittelsbacherplatz 2
W-8000 München 2(DE)**

(72) Erfinder: **Jensen, Peter-Grauer
Starupvej 225
DK-08340 Malling(DK)**

## Beschreibung

Moderne rechnergesteuerte Fernsprechvermittlungssysteme eröffnen eine Vielzahl von neuen Möglichkeiten bei der Benutzung des Telefons. Hierzu gehört beispielsweise die zeitversetzte Übermittlung von Sprachmitteilungen, die jeweils in einem bestimmten Speicherbereich einer zentralen Speicheranordnung, der einem Teilnehmer fest zugeordnet ist, hinterlegt werden können. Die Sprachspeicherung und die verwaltete Übermittlung der individuellen Informationen kann sowohl im öffentlichen Telefonnetz als auch in den Nebenstellenvermittlungssytemen realisiert werden. Derjenige, für den die Sprachmitteilungen in der zentralen Speicheranordnung hinterlegbar sind, kann diese zu einem von ihm freiwählbaren Zeitpunkt abrufen. Neben dem Aufsprechen der einzelnen Mitteilungen durch den Absender und dem Anhören durch den Empfänger ist es möglich, die Mitteilungen zu editieren. So kann beispielsweise beim Herstellen der Mitteilung der Absender diese löschen, ändern und korrigieren. Der Empfänger kann beispielsweise die für ihn bestimmte Mitteilung in Teilen oder auch mehrmals abhören. Der Absender hat die Möglichkeit eine Information darüber, ob und wann seine Mitteilung zugestellt worden ist, abzufragen. Ein unbefugter Empfang von Sprachmitteilungen wird u.a. dadurch verhindert, daß sich der Empfänger dem System gegenüber als berechtigt ausweisen muß.

Werden die Sprachinformationen, die auf der Empfangsseite im Sprachspeichersystem nach einer entsprechenden Umwandlung als digitale Datenfolgen bearbeitet werden, auf der Leitung als analoge Sprachsignale übertragen, so können diese auf dem Übertragungswege bedämpft werden. Dies könnte insbesondere dann zu Verständnisschwierigkeiten führen, wenn diese bedämpften Sprachinformationen nach ihrer Einspeicherung unter Zwischenschaltung einer gleichfalls bedämpften Übertragungsleitung von einem berechtigten Teilnehmer abgerufen werden.

Aus ELECTRONICS LETTERS, Band 16, Nr. 3, 31. Januar 1980, Seiten 96, 97, Londen, GB; J. FLOOD: "New digital automatic gain control for P.C.M. signals" ist bereits ein Verfahren und eine Anordnung zur Pegelregulierung von Nachrichteninformationen bekannt. Die bekannte Anordnung umfaßt vier Komparatoren, von denen zwei erste Komparatoren die Pegel von Sprachproben mit einem ersten, relativ hohen Pegelschwellwert und mit einem zweiten, relativ niedrigen Pegelschwellwert vergleichen. In Abhängigkeit davon, ob die zu vergleichenden Sprachprobenpegel größer als der/gleich dem ersten Pegelschwellwert sind, ob die zu vergleichenden Sprachprobenpegel zwischen dem ersten und zweiten Pegelschwellwert liegen, oder ob die zu vergleichenden Sprachprobenpegel kleiner als der zweite Pegelschwellwert sind, wird zu einer in einem Schieberegister abgespeicherten ersten Zahl eine zweite Zahl addiert bzw. von der ersten Zahl wird eine dritte Zahl subtrahiert bzw. die erste Zahl bleibt unverändert. Die aufgrund dieses Vergleichs der Sprachprobenpegel mit den beiden Pegelschwellwerten durch Addition bzw. Subtraktion modifizierte erste Zahl bzw. die aufgrund dieses Vergleichs unveränderte erste Zahl wird mittels zwei zweiter Komparatoren mit einer vierten und einer fünften Zahl verglichen. In Abhängigkeit dieses zweiten Vergleichs wird die Verstärkungssteuerinformation geändert bzw. nicht geändert. Die bekannte Anordnung ist insgesamt schaltungstechnisch komplex ausgestaltet und das Verfahren zur Änderung bzw. Nichtänderung der Verstärkungsinformation umfaßt eine Vielzahl von Einzelschritten.

Aus dem IBM TECHNICAL DISCLOSURE BULLETIN, Band 18, Nr. 2, Juli 1975, Seiten 438-439, New York, US; J. BESSEYRE: "Digital automatic gain control circuit" ist eine Anordnung zur automatischen Verstärkungssteuerung von PCM-Signalen bekannt, deren Bits einen Vorzeichenwert, einen Exponentenwert und einen Mantissenwert darstellen. Die eigentliche Verstärkungssteuerung erfolgt u.a. mittels Schaltungskomponenten, die in einem Rückkopplungszweig angeordnet sind. Dabei wird zunächst ein erster Wert gebildet, der der Signalenergie entspricht. Dieser Wert wird mit einem aus dem ersten Wert abgeleiteten zweiten Wert gebildet. Für den zweiten Wert wird jeweils ein Zwischenexponentenwert und ein Zwischenmantissenwert gebildet. Schließlich werden aus den ursprünglichen Exponenten- und Mantissenwerten sowie den Zwischenexponentenwerten und Zwischenmantissenwerten neue Exponenten- und Mantissenwerte gebildet. Auch diese Anordnung ist schaltungstechnisch komplex ausgestaltet und das mit der bekannten Anordnung durchgeführte Verfahren umfaßt eine Vielzahl von Rechenschritten.

Es ist die Aufgabe der Erfindung, für ein Verfahren der eingangs genannten Art die Auswirkung einer Bedämpfung unter Vermeidung von in den Leitungen einzuschaltenden Regeneratoren in schaltungstechnisch einfacher Weise zu vermindern.

Die Lösung dieser Aufgabe erfolgt mit den im Anspruch 1 angegebenen Merkmalen.

Die Pegelregulierung der als analoge Signale zunächst empfangenen Informationen erfolgt nach der Digitalisierung dieser Informationen. Dadurch können Verarbeitungsschritte, die für eine vorgesehene Weiterverarbeitung dieser digitalen Datenfolgen notwendig sind, bei der Regulierung herangezogen werden. Die für eine Verarbeitung zuständige Steuereinheit z.B. in Form eines Mikroprozessors kann aufgrund entsprechender Programmschritte die für eine Regulierung notwendigen Abläufe bewirken. Bei einer Verbindung, die einen hohen Sprachpegel zuläßt, wird ein diesem Pegel repräsentierender Wert festgehalten. Ist dieser Pegel während eines Teils dieser Verbindung oder während einer weiteren, durch eine Vermittlungsanlage vermittelten Verbindung kleiner, so wird nach einer Dekrementierung des vorab gespeicherten Wertes ein neuer, auf den geringerem Pegelwert abgestimmte Spitzenwert ermittelt. Bis zur Ausregelung auf einen neuen Spitzenwert wird demnach erfindungsgemäß eine bestimmte Zeitspanne beansprucht, so daß dadurch kurzzeitige leise Gesprächspassagen während einer Gesprächsverbindung erhalten bleiben. Sprünge in der Anhebung der Lautstärke sind insbesondere dann nicht registrierbar, wenn die in der Tabelle abgespeicherten und beispielsweise die notwendige Verstärkung festlegenden Werte sich auf die von einer nichtlinearen z.B. logrithmischen Kennlinie abgeleiteten digitalen Datenfolgen beziehen. Aufgrund der festgelegten Änderungswerte wird zur Vermeidung von Verzerrungen die aufgrund einer linearen Umwandlungskennlinie gebildeten digitale Datenfolge herangezogen.

Die in der abgespeicherten Tabelle enthaltenen Werte für die notwendige Verstärkung können so festgelegt sein, daß sich in einem bestimmten Dämpfungsbereich für die übertragenen Informationen ein angenähert gleichbleibender Digitalwert einstellt. Nach einer digitalen Weiterverarbeitung und erneuter Umsetzung in analoge Sprachsignale ergibt sich für diese somit eine für das einwandfreie Verständnis notwendige Lautstärke.

Weitere Ausbildungen der Erfindung sind den restlichen Unteransprüchen zu entnehmen.

Das erfindungsgemäße Verfahren wird anhand der Figuren dargestellt. Es sind nur die zum Verständnis erforderlichen Einzelheiten gezeigt.

Fig. 1     zeigt in einem vereinfachten Blockschaltbild eine Nebenstellenanlage, die mit einer Einheit zur Bearbeitung und Abspeicherung von Sprachinformationen gekoppelt ist, bei der das erfindungsgemäße Verfahren zur Anwendung kommt.

Fig. 2     zeigt Diagrammdarstellungen, die der Erläuterung des erfindungsgemäßen Verfahrens dienen.

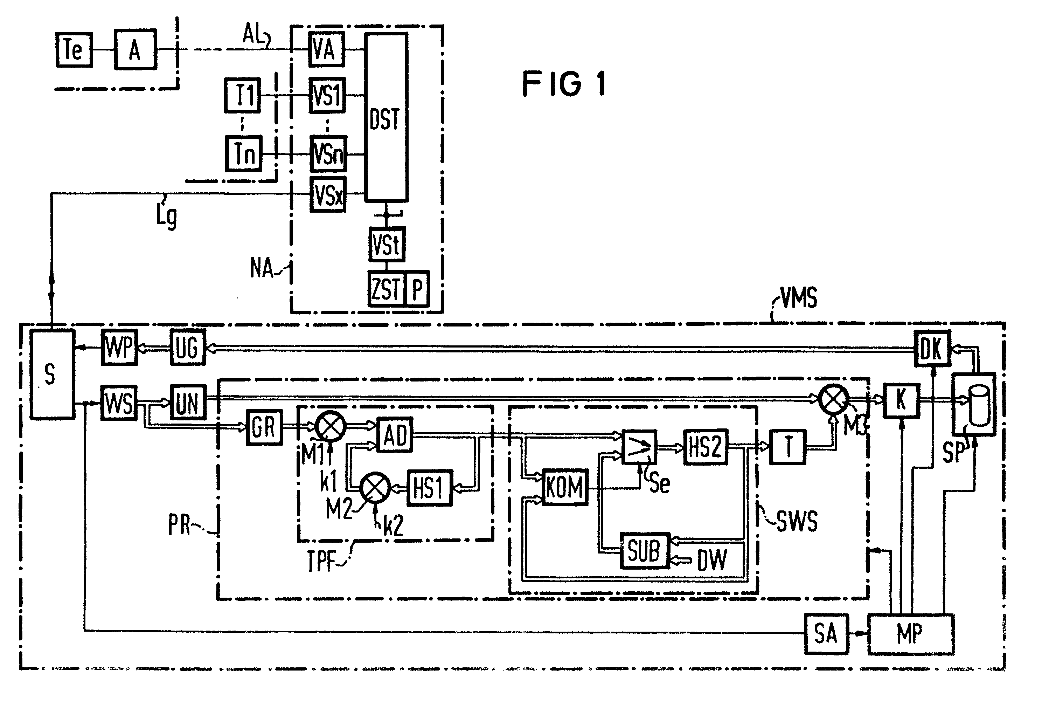

Es sind in einem stark vereinfachten Blockschaltbild Teile einer Nebenstellenanlage NA dargestellt, die beispielsweise eine rechnergesteuerte speicherprogrammierte Vermittlungsanlage sein kann. Die zentrale Steuereinrichtung ZST steuert im wesentlichen die für die einzelnen Betriebsmöglichkeiten der Anlage erforderlichen Abläufe. Dabei greift sie auf entsprechende Programmteile zurück, die in der ihr zugeordneten Speichereinrichtung P abgespeichert sind. Mit VSt ist eine Verteilersteuerung und mit DST eine dezentrale Steuerung, der jeweils eine bestimmte Anzahl von Einrichtungen, wie beispielsweise Teilnehmerstellen T1 bis Tn zugeordnet sind, bezeichnet. Unter der Voraussetzung eines digitalen Vermittlungssystems ist diese dezentrale Teilsteuerung DST funktionsmäßig ein rechnergesteuerter Speicherbereich, in den die digitalen Sprachsignale eingespeichert und zum jeweiligen Verbindungspartner ausgelesen werden. Sie stellt also das digitale Koppelnetz dar. Die Einheit VST ist eine spezielle Verteiler- und Anpaßungssteuerung, um mehrere dezentrale Teilsteuerungen DST, an die jeweils Sätze angekoppelt sind, bedienen zu können. So erfolgt beispielsweise die Anschaltung der Teilnehmerstellen T1 bis Tn über die Sätze VS1 bis VSn. Über ein Amtsleitungsbündel bzw. über eine Amtsleitung AL ist die Nebenstellenanlage NA mit einer externen Anlage, beispielsweise mit der Vermittlungsanlage A des öffentlichen Netzes verbunden. Stellvertretend für die daran angeschlossenen Endgeräte ist als Endgerät die Teilnehmerstelle Te dargestellt. Der weiterführenden Leitung AL bzw. dem weiterführenden Leitungsbündel ist ein Vermittlungssatz VA zugeordnet. Die insgesamt dargestellten Vermittlungssätze der Nebenstellenanlage können als aktive Sätze ausgebildet sein, die einen Prozessor beinhalten. Durch diesen wird dann eine gewisse Vorverarbeitung von Informationen durchgeführt, die z.B. von den in einem Teilnehmersatz enthaltenen Indikationsstellen geliefert werden. Es kann beispielsweise vorgesehen sein, daß neben dem im Regelfall vorgesehenen digitalen Endeinrichtungen auch analoge Endeinrichtungen über die entsprechend ausgebildete Sätze angeschlossen sind. Es können also sowohl über eine Amtsleitung AL als auch über eine Teilnehmeranschlußleitung Verbindungen vermittelt werden, denen analoge Sprachinformationen zugrunde liegen. Es ist vorgesehen, daß sowohl in digitaler Form übermittelte Sprachinformationen als auch solche, die als analoge Sprachinformationen übermittelt werden, in einem über einen entsprechenden Satz VSx an die Vermittlungsanlage NA angeschlossenen Sprachspeichersystem VMS verarbeitet werden. In einer Speichereinrichtung SP werden Sprachmitteilungen, die für einen bestimmten Teilnehmer erfolgen, abgespeichert. Dieser Teilnehmer hat dann die Möglichkeit, die Mitteilung gezielt abzufragen. Sowohl beim Erstellen einer Nachricht als auch beim Abhören derselben stehen dem Teilnehmer verschiedene Bedienfunktionen zur Verfügung. Hierzu gehören beispielsweise Start/Stop der Ein- bzw. Ausgabe, Wiederholung der Nachricht, Vorlauf/Rücklauf, das Löschen und Ändern einer Nachricht. Eine solche Sprachmitteilung kann auch durch weitere Informationen, wie beispielsweise die Identität des Absenders, den Zeitpunkt des Absendens usw. ergänzt sein. Sind im Speicher SP Nachrichten für einen Teilnehmer eingetroffen, so kann ihm dies signalisiert werden. Für die neue zeitversetzte Art der Kommunikation, die eine zentrale Sprachspeicherung und die verwaltete Übermittlung der Sprachmitteilungen ermöglicht, kann als Endgerät der vorhandene Fernsprechapparat verwendet werden. Der Teilnehmer signalisiert seine Bedienwünsche durch Betätigen des Gabelkontaktes und der Wählvorrichtung. In umgekehrter Richtung kann er Wecker- und Ruftöne sowie aus einem entsprechenden Speicher entnommene gesprochene Anweisungen erhalten. Zur Beanspruchung der einzelnen Funktionen des Sprachspeichersystems VMS wählt also der Teilnehmer, der eine Sprachmitteilung für einen anderen Teilnehmer einspeichert, bestimmte Ziffern oder Ziffernkombinationen eine.Aufgrund dieser Steuerinformationen wird dann der jeweils zugeordnete Funktionsablauf veranlaßt. Die ankommenden Sprachinformationen können in der Weise vorbearbeitet sein, daß sie über die Leitungsverbindung Lg als PCM-codierte Signalfolgen anliegen und über die Schnittstelle S weitergegeben werden. Nach der Analog/Digital-Wandlung der eintreffenden analogen Sprachsignale können die entsprechenden, aus den Abtastwerten gebildeten digitalen Signale zunächst als serielle Signale auftreten, die dann nach Durchlaufen der Schnittstelle S nach einer Seriell/Parallelwandlung WS in paralleler Form abgegeben werden. Die Verbindung mit den nachfolgenden Einheiten erfolgt über Leitungsanordnungen, die aus einer der Anzahl der Bits entsprechenden Anzahl von Einzelleitungen bestehen. Derartige Leitungsanordnungen sind in der Figur 1 durch zueinander parallele Verbindungslinien dargestellt. Für die Weiterverarbeitung werden die durch die Einheit WS zur Verfügung gestellten digitalen Informationen, die aufgrund einer der Quantisierung zugrundeliegenden nichtlinearen, im Regelfall logarithmischen Kennlinie gebildet werden, in aufgrund einer linearen Kennlinie abgeleitete Informationen umgesetzt. Dies soll durch die Einheit UN erfolgen. Die von ihr abgegebenen digitalen Dateninformationen werden, wie später noch erläutert wird, in der Einheit PR hinsichtlich ihres Pegels reguliert und der Einheit K zugeführt. In dieser Einheit K wird eine Vorverarbeitung der eintreffenden Informationen vorgenommen, um den Speicheraufwand, der für die vorgesehene Einspeicherung in der Einheit SP notwendig ist, zu reduzieren. Eine Möglichkeit dieser Vorverarbeitung besteht beispielsweise darin, die PCM-Signale in sogenannte ADPCM-Signale umzuwandeln. Dieses Vorverarbeitungsverfahren, mit dem das digitalisierte Sprachsignal in komprimierter Form gespeichert werden kann, wird als das adaptive Differenz-PCM-Verfahren bezeichnet. Diese für sich bekannte Vorverarbeitung erfolgt in Abhängigkeit von Steuerinformationen, die von der Steuereinheit MP, die einen Mikroprozessor darstellen kann, abgegeben werden. Die Steuereinheit MP, die Zugriff zu entsprechenden Programmspeichern hat, steuert die Abläufe in der Einrichtung VMS. Neben den Steuerabläufen in der Einrichtung PR werden durch die Steuerrechnereinheit MP die Ein- bzw. Ausspeichervorgänge der Speichereinrichtung SP gesteuert. Dies trifft in gleicher Weise auch für die Einspeicherung von begleitenden Informationen, wie beispielsweise der Identität des die Nachricht absendenden Teilnehmers oder des Zeitpunktes des Absendens zu. Als Eingangsinformation für das Sprachverarbeitungs- und Speichersystem VMS steht im Regelfall ein Informationsfluß zur Verfügung, in dem neben den Sprachinformationen auch Steuerinformationen enthalten sind. Mit diesen Steuerinformationen kann ein Teilnehmer des Fernsprechvermittlungssystems beim Erstellen einer Sprachmitteilung die Ansteuerung der Einrichtung VMS bewirken und diese Sprachmitteilungen editieren. Zu diesem Zweck werden auch Steuerinformationen zwischen den Sprachinformationen abgesetzt. Der nach der Schnittstelle S zur Verfügung stehende Informationsfluß wird auch einer Signalauswerteeinrichtung SA zugeführt. Diese liefert für die Steuerrechnereinheit MP Informationen darüber, ob zu einem bestimmten Zeitpunkt eine Steuerinformation oder eine Sprachinformation auftritt. Wird eine Steuerinformation erkannt, so wird durch von der Einheit MP abgegebene Steuersignale während der Zeit, in der eine solche Steuerinformation vorhanden ist, die Einspeicherung in die Speichereinheit SP unterbunden. Durch die Tatsache, daß also die Einspeicherung von Steuerinformationen unterbleibt, wird bei der Wiedergabe der gespeicherten Informationen eine durch solche Steuerinformationen bedingte unerwünschte Störung vermieden. Solche Steuerinformationen werden nämlich als im Mehrfrequenzverfahren abgegebene MFV-Zeichen übermittelt.

Auch bei der Ausspeicherung einer Nachricht aus der Speichereinrichtung SP werden von dem hierzu berechtigten Teilnehmer zunächst Steuerinformationen übermittelt. Aufgrund von eingawählten Kennzahlen kann sich beispielsweise der betreffende Teilnehmer gegenüber dem Sprachspeichersystem VMS als berechtigt ausweisen oder er kann den Wunsch nach Wiederholung einer Nachricht signalisieren. Diese Steuerinformationen werden ebenfalls von der Einheit SA ausgewertet und führen zu entsprechenden Informationen für die Steuerrechnereinheit MP. Die Einheit DK dient dazu, die in komprimierter Form in der Speichereinrichtung SP enthaltenen Informationen nach dem Ausspeichern in normal codierte PCM-Informationen umzuwandeln. Bevor die Informationen über die Schnittstelle S unter Einbeziehung der Vermittlungsanlage NA zu einer Teilnehmerstelle, beispielsweise zu der Teilnehmerstelle T1,übertragen werden, kann noch eine Umwandlung der in paralleler Form abgegebenen digitalen Informationen in seriell auftretende digitale Informationen vorgenommen werden. Dies soll durch die Einheit WP erfolgen. Bevor die auszuspeichernden Informationen dieser Einheit zugeführt werden, findet in der Einheit UG eine Umsetzung der aufgrund einer linearen Kennlinie gebildeten digitalen Informationen in solche Informationen statt,denen erneut eine logarithmische Kennlinie zugrunde liegt.

Das Sprachspeichersystem VMS steht neben den Teilnehmern der Anlage NA auch externen Teilnehmern zur Verfügung. Bei einer Fernverbindung kann diese mit starker Dämpfung behaftet sein. Wird die über eine solche bedämpfte Leitung übermittelte Sprachinformation eingespeichert, so kann bei der Wiedergabe die Nachricht schwer verständlich sein. Dies ist in einem umso größeren Maße der Fall, wenn die für die Wiedergabe beanspruchte Fernsprechverbindung ebenfalls mit einer starken Dämpfung behaftet ist. Um die Verständlichkeit bei der Wiedergabe sicherzustellen, wird durch die Einheit PR eine Pegelregulierung vorgenommen. Hierzu wird der mittlere Sprachpegel festgestellt und je nach Größe dieses vorhandenen Sprachpegels eine unterschiedliche Anhebung und ggf. eine Verminderung bewirkt. Um dabei Verzerrungen zu vermeiden, wird hierzu die an der Einheit UN in paralleler Form anliegende und in ihr aufgrund einer linearen Kennlinie umgesetzte digitale Signalfolge herangezogen. Die Änderung erfolgt durch den Multiplizierer M3, dem der für die Änderung der einzelnen digitalen Werte erforderliche Multiplikationsfaktor, der somit z.B. die vorzunehmende Verstärkung bestimmt,mitgeteilt wird.Die Ermittlung dieses Multiplikationsfaktors erfolgt unter Mitwirkung der Einheiten GR, TPF, SWS und der Einheit T. Die von der Einheit WS in paralleler Form abgegebenen digitalen Signalwerte werden durch die Einheit GR gleichgerichtet. Das bedeutet, daß das einen positiven Signalwert charakterisierende Bit unverändert bleibt und das einen negativen Signalwert charakterisierende Bit in ein Bit umgewandelt wird, das dem eines positiven Signalwertes entspricht. Nach dieser Vorzeichenumsetzung werden die Informationen einem Mittelungsfilters TPF zugeführt, das beispielsweise als rekursiver Tiefpaß ausgebildet ist. Im Ausführungsbeispiel enthält dieser für sich bekannte Tiefpaß einen Addierer AD, der an seinem Ausgang eine gemittelte Größe an einen Spitzenwertspeicher SWS abgibt und gleichzeitig den Ausgangswert einem ihn mitbildenden Haltespeicher HS1 zuführt. Dadurch wird das digitale Signal um eine einem Abtastintervall der Analog/Digitalwandlung entsprechende Zeitspanne verzögert an einen Multiplizierer M2 weitergegeben. Für diesen Multiplizierer wird ein Parameter k2 bereitgestellt. Dieser Parameter ist in gleicher Weise wie der für den weiterhin vorhandenen Multiplizierer M1 bereitgestellte Parameter k1 eine konstante, die Charakteristik des Filters mitbestimmende Größe. Der Parameter k2, der beispielsweise den Wert 0,9 hat, dient zur Festlegung der sogenannten Eckfrequenz des Tiefpaßfilters. Die mit dem Filterparameter k2 multiplizierte Größe wird den ersten Eingängen des Addierers AD zugeführt. Über zweite Eingänge dieses Addierers AD wird ihm die vom Multiplizierer M1 abgegebene Ausgangsgröße zugeleitet. Der Multiplizierer M1 multipliziert die von der Einheit GR abgegebenen digitalen Informationen mit dem durch k1 festgelegten Filterparameter. Für diesen Filterparameter kann beispielsweise der Wert 0,1 vorgegeben sein. Durch den Addierer AD wird somit das vom Multiplizierer M1 gelieferte Signal zu dem nach der vorgenommenen Verzögerung vom Multiplizierer M2 gelieferten Signal hinzu addiert. Es wird an seinem Ausgang als Summensignal eine gemittelte Größe abgegeben. Mit dem Spitzenwertspeicher SWS wird nun ein Spitzenwert der vom Tiefpaß TPF her anliegenden digitalen Informationen festgestellt.

Die vom Tiefpaßfilter TPF gelieferte digitale Information wird im Komparator KOM mit dem im Haltespeicher HS2 abgespeicherten Digitalwert verglichen. Ergibt dieser Vergleich, däß diese Information wertemäßig größer ist als die in diesem Haltespeicher enthaltene Information, so wird der Selektor Se durch ein vom Komparator abgegebenes Signal so eingestellt, daß die jeweilige Eingangsinformation in den Haltespeicher HS2 übernommen wird. Ergibt der vorgenommene Vergleich, daß die Eingangsinformation kleiner als die durch den Haltespeicher vorgegebene Information ist, so wird an Stelle des bisher im Haltespeicher enthaltenen Wertes ein Wert eingeschrieben, der um einen bestimmten Digitalwert DW kleinerist.Dies wird dadurch ermöglicht, daß der im Haltespeicher HS2 jeweils enthaltene Wert dem Subtrahierer SUB zugeführt wird, der davon dann jeweils im Rhythmus des Abtasttaktes den Wert DW subtrahiert. Durch den Komparator KOM ist der Selektor Se dann jeweils so eingestellt, daß der vom Subtahierer gelieferte Wert in den Haltespeicher HS2 übernommen wird. Bei dieser Dekrementierung des im Haltespeicher enthaltenen Wertes verbleibt dieser also immer in der einem Abtastintervall entsprechenden Zeitspanne in dem Haltespeicher. Die geschilderte Verminderung des Haltespeicherwertes um den Dekrementwert DW setzt sich solange fort, bis ein Wert erreicht wird, der kleiner ist als der jeweilige Eingangswert. Derjenige Eingangswert,der dann größer ist als derjenige der nach der stufenweisen Verminderung erreicht wird, wird im Haltespeicher HS2 als der für die betreffende Gesprächsverbindung maßgebende Spitzenwert nach einer Abtastzeitspanne übernommen. Durch die Wahl des jeweiligen Dekrementwertes, der dann als fester Wert vorgegeben ist, kann das Aus schwingverhalten beeinflußt werden. Dadurch ist normalerweise die Zeitspanne, nach der bei der Dekrementierung ein neuer Eingangswert in den Haltespeicher übernommen wird , so groß, daß die Gesprächscharakteristik erhalten bleibt. Die Pegelverminderung, die dadurch entsteht, daß bei der Übermittlung der Sprachinformation kurzzeitig leiser gesprochen wird, führt in der Einheit PR nicht zu einer Pegeländerung. Eine solche Änderung wird erst dann vorgenommen, wenn der sich aus den Eingangsinformationen ergebende Sprachpegel über eine längere Zeit von beispielsweise 10 Sekunden einen niedrigen Wert aufweist. Eine solche Änderung im Sprachpegel kann durch Leitungsparameter theoretisch auch während einer bestehenden Verbindung auftreten. Normalerweise ist die aufgrund eines niedrigeren Sprachpegels notwendige Übernahme eines neuen Spitzenwertes in den Haltespeicher HS2 bei einer nachfolgenden Verbindung erforderlich, die eine hohe Bedämpfung aufweist. Es wird dann über die geschilderte Dekrementierlogik ein mittlerer Sprachpegel bei dieser neuen Verbindung ermittelt und der geänderte Wert im Haltespeicher HS2 festgehalten. Dieser Wert repräsentiert dann den mittleren Sprachpegel, der sich aus der betreffenden Verbindung ableitet. Wenn demnach über einen längeren zeitlichen Bereich ein niedriger Pegel vorhanden ist, geht man davon aus, daß eine Bedämpfung der Übertragungsleitung gegeben ist. Es muß also in einem solchen Fall eine Anhebung des Sprachpegels vorgenommen werden. Der Betrag und die Richtung einer vorzunehmenden Änderung im anliegenden Signal ist einer abgespeicherten Tabelle T zu entnehmen. Diese Tabelle wird mit den im Haltespeicher HS2 enthaltenen Werten abgefragt und sie liefert als Ergebnis dieser Abfrage den Faktor, mit dem der Multiplizierer M3 mit dem vorhandenen Systemtakt das jeweils anstehende Signal verändert. Die der abgespeicherten Tabelle T entnehmbaren Werte, über die also die Richtung und die Größe der Verstärkung regelbar ist, sind so festgelegt, daß in einem bestimmten db-Bereich für das Eingangssignal am Ausgang des Multiplizierers M3 ein bestimmter mittlerer Sprachpegel von z.B. -15 dB erreicht wird. Es kann eine Änderungsmöglichkeit für den gewünschten Sprachpegel vorgesehen sein. Hierzu wird dann ein anderer Bereich der abgespeicherten Tabelle herangezogen. Der jeweils maßgebende Bereich ist durch die Steuereinheit MP bestimmbar. Die am Ausgang des Multiplizierers M3 auftretenden Signalinformationen werden in der bereits geschilderten Weise über die Einheit K in der Speichereinheit SP abgespeichert und können von dort abgerufen werden.

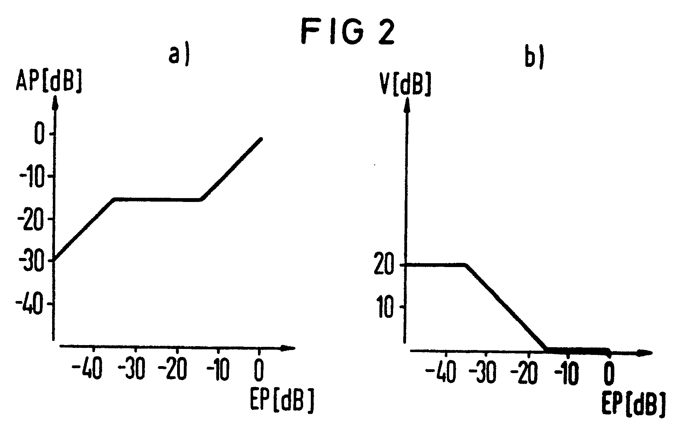

Die Regelcharakteristik ist den in der Figur 2 beispielhaft dargestellten Kennlinien zu entnehmen. Das mit dem Bezugszeichen a versehene Diagramm zeigt den am Ausgang des Multiplizierers M3 entstehenden Ausgangspegel AP in Abhängigkeit von dem Eingangspegel EP. Die Pegel sind jeweils in db-Werten angegeben und vermindern sich ausgehend von dem Wert Null db.

Durch die geschilderte Regelung wird in diesem Ausführungsbeispiel erreicht, daß sich in einem Bereich von -15 dB bis -35 dB für den Eingangspegel ein annähernd konstanter Ausgangspegel von -15 dB ergibt. Bei noch kleineren Eingangspegeln wird zumindest eine Anhebung vorgenommen. In dem mit dem Bezugszeichen b versehenen Diagramm der Figur 2 ist die Verstärkung V in Abhängigkeit vom Eingangspegel EP dargestellt. Bis zu einem Eingangspegel von -15 dB bleibt die Verstärkung bei dem Wert von Null dB. Vermindert sich der Eingangspegel, so wird bis zu einem Eingangspegel von 35 dB die Verstärkung in der dargestellten Weise erhöht. In dem gezeigten Beispiel wird eine maximale Verstärkung von 20 dB erreicht, die auch bei einer weiteren Verminderung des Eingangspegels erhalten bleibt.

Im Ausführungsbeispiel nach der Figur 1 werden für die Ermittlung des Spitzenwertes eines mittleren Sprachpegels die Informationen herangezogen, die vom Seriell/Parallelwandler WS geliefert werden. Es ist auch denkbar, den Gleichrichter GR und den nachgeschalteten Einheiten diejenigen digitalen Signale zuzuführen, die am Ausgang des Multiplizierers M3 auftreten. Es ergibt sich bei dieser rückholenden Regelung eine Regelcharakteristik, die einen nicht so idealen Verlauf wie die bei der bereits beschriebenen Regelung aufweist. Für die Ableitung des Faktors für den Multiplizierer würde dann ein Signal verwendet werden, daß sich weniger verändert als es bei der bereits beschriebenen, als Vorwärtsregelung zu bezeichnenden Regelungsart der Fall ist. Diejenigen Werte, die der abgespeicherten Tabelle aufgrund der im Haltespeicher jeweils enthaltenen Größen entnehmbar sind, würden bei dieser rückholenden Regelung in einem anderen Wertbereich liegen.

## Patentansprüche

1. Verfahren zur Pegelregulierung von Nachrichtensignalen, die als aus Abtastwerten, insbesondere von über Leitungen eines Fernsprechübermittlungsnetzes übertragener Sprachsignale, gewonnene pulscodemodulierte Datenfolge dargestellt sind,

**dadurch gekennzeichnet,**
daß für vorgegebene, aufeinanderfolgende Zeitintervalle ermittelte mittlere Sprachpegel (EP) übertragener Sprachsignale aufeinanderfolgend mit jeweils einem Pegelschwellwert verglichen werden, daß abhängig von dem Vergleichsergebnis in einem ersten Fall, in dem der mittlere Sprachpegel (EP) den Pegelschwellwert überschreitet, der mittlere Sprachpegel (EP) als neuer Pegelschwellwert für einen anschließenden Vergleich mit einem anschließend ermittelten mittleren Pegel übertragener Sprachsignale übernommen wird, daß abhängig von dem Vergleichsergebnis in einem zweiten Fall, in dem der mittlere Sprachpegel (EP) den Pegelschwellwert unterschreitet, dieser mit der Abtastfrequenz stufenweise vermindert um einen vorgegebenen Pegeldifferenzwert (DW) als neuer Pegelschwellwert für den anschließenden Vergleich übernommen wird, daß in dem ersten und zweiten Fall die Datenfolge durch eine Steuerinformation in der Weise geändert wird, daß der mittlere Sprachpegel (EP) in Abhängigkeit von seinem Vergleichspegelschwellwert auf einen vorgegebenen Pegelwert (AP) eingestellt wird, und daß die in der übertragenen pulscodemodulierten Datenfolge enthaltenen Sprachsignale, die aufgrund einer der Quantisierung zugrundeliegenden nichtlinearen Umwandlungskennlinie umgewandelt wurden, vor der Beaufschlagung mit der Steuerinformation aufgrund einer der Quantisierung zugrundeliegenden linearen Umwandlungskennlinie in eine modifizierte Datenfolge umgewandelt werden.

2. Verfahren nach Anspruch 1,
**dadurch gekennzeichnet,**
daß die Steuerinformation durch einen Multiplikationsfaktor gebildet wird, mit dem der mittlere Pegel (EP) im Anschluß an den Vergleich multipliziert wird.

3. Verfahren nach Anspruch 1 oder 2,
**dadurch gekennzeichnet,**
daß die übertragene pulscodemodulierte Datenfolge vor der Ermittlung des mittleren Sprachpegels (EP) einer Gleichrichtung unterzogen wird.

4. Vorrichtung zur Durchführung des Verfahrens nach Anspruch 1,
**dadurch gekennzeichnet,**
daß sie eine Einheit (GR, TPF) zur Ermittlung des mittleren Sprachpegels (EP) der übertragenen Datenfolge aufweist, daß dieser Einheit (GR, TPF) ein Spitzenwertspeicher (SWS) nachgeschaltet ist, der eingangsseitig einen Komparator (KOM) und einen Selektor (Se) mit je einem die übertragene Datenfolge aufnehmenden ersten und je einen zweiten Eingang aufweist, daß der Komparator (KOM) ausgangsseitig mit einem Steuereingang des Selektors (Se) verbunden ist, der seinerseits ausgangsseitig mit einem Haltespeicher (HS2) verbunden ist, daß der Ausgang des Haltespeichers (HS2) sowohl auf den Subtrahendeingang einer Subtrahiereinheit (SUB) als auch auf den zweiten Eingang des Komparators (KOM) führt, daß die Stubrahiereinheit (SUB) ferner einen, mit einer den Pegeldifferenzwert (DW) erzeugenden Quelle verbundenen Minuendeingang aufweist und ausgangsseitig mit dem zweiten Eingang des Selektors (Se) verbunden ist, daß dem Spitzenwertspeicher (SWS) eine von dem Haltespeicher (HS2) angesteuerte Tabelle (T) mit den Vergleichsschwellwerten zugeordneten Steuerinformationen zur Pegelregulierung der Datenfolge nachgeschaltet ist.

5. Vorrichtung nach Anspruch 4,
**dadurch gekennzeichnet,**
daß der die mittleren Sprachpegel (EP) ermittelnden Einheit (GR, TPF) eine Einheit (UN) vorgeschaltet ist, die die in der Datenfolge enthaltenen Sprachsignale, die aufgrund einer der Quantisierung zugrundeliegenden, nichtlinearen Umwandlungskennlinie umgewandelt wurden, aufgrund einer der Quantisierung zugrundeliegenden linearen Umwandlungskennlinie in die modifizierte Datenfolge umwandelt.

**Claims**

1. Level control method for information signals, which are represented as a pulse code modulated data sequence obtained from sampled values, particularly from speech signals transmitted over lines of a telephone communications network, characterised in that mean speech levels (EP) of transmitted speech signals derived for prescribed successive time intervals are successively compared with in each case one level threshold, in that depending on the result of the comparison, in a first case, in which the mean speech level (EP) exceeds the level threshold, the mean speech level (EP) is substituted as the new level threshold for a subsequent comparison with a subsequently derived mean level for transmitted speech signals, in that, depending on the result of the comparison in a second case, in which the mean speech level (EP) is less than the level threshold, the latter is substituted, reduced in steps at the sampling frequency by a prescribed level difference value (DW), as the new level threshold for the subsequent comparison, in that in the first and second case the data sequence is modified by means of a control information item in such a manner that the mean speech level (EP) is set as a function of its comparison level threshold to a prescribed level value (AP), and in that the speech signals contained in the transmitted pulse code modulated data sequence, which have been converted on the basis of a non-linear conversion characteristic line based on the quantisation, are converted into a modified data sequence before the application of the control information item on the basis of a linear conversion characteristic line based on the quantisation.

2. Method according to Claim 1, characterised in that the control information item is formed by means of a multiplication factor, by which the mean level (EP) is multiplied following the comparison.

3. Method according to Claim 1 or 2, characterised in that the transmitted pulse code modulated data sequence is subjected to a rectification before the derivation of the mean speech level (EP).

4. Device for carrying out the method according to Claim 1, characterised in that it has a unit (GR, TPF) for the derivation of the mean speech level (EP) of the transmitted data sequence, in that connected downstream of this unit (GR, TPF) there is a peak hold (SWS), which on the input side has a comparator (KOM) and a selector (Se) having in each case a first input receiving the transmitted data sequence and in each case a second input, in that the output side of the comparator (KOM) is connected to a control input of the selector (Se), the output side of which, for its part, is connected to a hold latch (HS2), in that the output of the hold latch (HS2) is supplied both to the subtrahend input of a subtraction unit (SUB) and to the second input of the comparator (KOM), in that the subtraction unit (SUB) furthermore has a minuend input, connected to a source generating the level difference value (DW), and on the output side is connected to the second input of the selector (Se), in that connected downstream of the peak hold (SWS) there is a table (T), addressed by the hold latch (HS2) and having the control information items allocated to the comparison thresholds for regulating the level of the data sequence.

5. Device according to Claim 4, characterised in that connected upstream of the unit (GR, TPF) deriving the mean speech level (EP) there is a unit (UN), which converts the speech signals contained in the data sequence, which have been converted on the basis of a non-linear conversion characteristic line based on the quantisation, into the modified data sequence on the basis of a linear conversion characteristic line based on the quantisation.

**Revendications**

1. Procédé pour régler le niveau de signaux d'informations, qui sont représentés sous la forme d'une suite de données modulée selon une modulation par impulsions codées et obtenue à partir de valeurs d'échantillonnage, notamment de signaux vocaux transmis par l'intermédiaire de lignes d'un réseau de transmission téléphonique,
caractérisé par le fait
que l'on compare successivement, respectivement à une valeur de seuil de niveau, des niveaux vocaux moyens (EP), déterminés pour des intervalles de temps successifs prédéterminés, de signaux vocaux transmis, qu'en fonction du résultat de la comparaison, dans un premier cas dans lequel le niveau vocal moyen (EP) dépasse la valeur de seuil du niveau, le niveau vocal moyen (EP) est transféré en tant que nouvelle valeur de seuil du niveau pour une comparaison ultérieure à un niveau moyen, déterminé ultérieurement, de signaux vocaux transmis, qu'en fonction du résultat de la comparaison, dans un second cas dans lequel le niveau vocal moyen (EP) tombe au-dessous de la valeur de seuil du niveau, cette valeur est transmise en étant réduite par échelons au moyen de la fréquence d'échantillonnage, d'une valeur prédéterminée de différence de niveau (DW), en tant que nouvelle valeur de seuil de niveau pour la comparaison ultérieure, que dans les premier et second cas, la suite de données est modifiée par une information de commande de telle sorte que le niveau vocal moyen (EP) est réglé, en fonction de sa valeur de seuil de niveau de comparaison, à une valeur de niveau prédéterminée (AP) et que les signaux vocaux, qui sont contenus dans la suite de données transmise, modulée selon une modulation par impulsions codées et qui ont été convertis sur la base d'une courbe caractéristique non linéaire de conversion utilisée pour la quantification, sont convertis, avant le chargement avec l'information de commande, en une suite modifiée de données, sur la base d'une courbe caractéristique linéaire de conversion utilisée pour la quantitifcation.

2. Procédé suivant la revendication 1, caractérisé par le fait que l'information de commande est formée au moyen d'un facteur multiplicatif, au moyen duquel le niveau moyen (EP) est multiplié à la suite de la comparaison.

3. Procédé suivant la revendication 1 ou 2, caractérisé par le fait que la suite de données transmise et modulée selon une modulation par impulsions codées est soumise à un redressement avant la détermination du niveau vocal moyen (EP).

4. Dispositif pour la mise en oeuvre du procédé suivant la revendication 1, caractérisé par le fait qu'il comporte une unité (GR,TPF) servant à déterminer le niveau vocal moyen (EP) de la suite de données transmise, qu'en aval de cette unité (GR,TPF) est branchée une mémoire de valeurs maximales (SWS), qui comporte, côté entrée, un comparateur (KOM) et un sélecteur (Se) possédant respectivement une première entrée, qui reçoit la suite de données transmise, et respectivement une seconde entrée, que le comparateur (KOM) est raccordé, côté sortie, à une entrée de commande du sélecteur (Se), qui est raccordé pour sa part, côté sortie, à une mémoire de retenue (HS2), que la sortie de la mémoire de retenue (HS2) est raccordée aussi bien à l'entrée du nombre à soustraire d'une unité de soustraction (SUB) qu'à la seconde entrée du comparateur (KOM), que l'unité de soustraction (SUB) comporte en outre une entrée du minuende, qui est raccordée à une source produisant la valeur de différence de niveau (DW), et est raccordée, côté sortie, à la seconde entrée du sélecteur (Se), et qu'en aval de la mémoire de valeurs maximales (SWS) est branché un panneau (T) commandé par la mémoire de retenue (HS2) et contenant les informations de commande, associées aux valeurs de seuil de comparaison, pour la régulation du niveau de la suite de données.

5. Dispositif suivant la revendication 4, caractérisé par le fait qu'en amont de l'unité (GR,TPF) qui détermine le niveau vocal moyen (EP), est branchée une unité (UN), qui convertit les signaux vocaux, qui sont contenus dans la suite de données et qui ont été convertis sur la base d'une courbe caractéristique non linéaire de conversion, prise pour base lors de la quantification, en la suite de données modifiée, sur la base d'une courbe caractéristique linéaire de conversion utilisée pour la quantification.

FIG 1

# FIG 2

a)

AP[dB]

b)

V[dB]